(19) Europäisches Patentamt
European Patent Office
Office européen des brevets

(11) Veröffentlichungsnummer : **0 331 000 B1**

# (12) EUROPÄISCHE PATENTSCHRIFT

(45) Veröffentlichungstag der Patentschrift : **18.09.91 Patentblatt 91/38**

(51) Int. Cl.$^5$ : **C23C 18/38**

(21) Anmeldenummer : **89103148.6**

(22) Anmeldetag : **23.02.89**

## (54) Verwendung von Polyacetalen als Komplexbildner zur chemischen Abscheidung von Kupfer und Verfahren zur chemischen Abscheidung von Kupfer.

(30) Priorität : **27.02.88 DE 3806306**

(43) Veröffentlichungstag der Anmeldung : **06.09.89 Patentblatt 89/36**

(45) Bekanntmachung des Hinweises auf die Patenterteilung : **18.09.91 Patentblatt 91/38**

(84) Benannte Vertragsstaaten : **DE ES FR GB IT NL SE**

(56) Entgegenhaltungen :
**DE-A- 3 034 877**
**DE-A- 3 238 921**
**US-A- 4 503 131**

(73) Patentinhaber : **BASF Aktiengesellschaft**
**Carl-Bosch-Strasse 38**
**W-6700 Ludwigshafen (DE)**

(72) Erfinder : **Oftring, Alfred, Dr.**
**Im Roehrich 49**
**W-6702 Bad Duerkheim (DE)**
Erfinder : **Tschang, Chung-Ji, Dr.**
**Hinterbergstrasse 31**
**W-6702 Bad Duerkheim (DE)**
Erfinder : **Winkler, Ekhard, Dr.**
**Pfalzring 74**
**W-6704 Mutterstadt (DE)**
Erfinder : **Gotsmann, Guenther, Dr.**
**Max-Beckmann-Strasse 15**
**W-6710 Frankenthal (DE)**
Erfinder : **Glaser, Klaus**
**Neuweg 14**
**W-6704 Mutterstadt (DE)**

**EP 0 331 000 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft die Verwendung von Polyacetalen aus Dialdehyden und Polyolcarbonsäuren als Komplexbildner in Bädern zur chemischen Abscheidung von Kupfer und ein Verfahren zur chemischen Abscheidung von Kupfer.

Die chemische, d.h. stromlose, Abscheidung von Kupfer findet Anwendung bei der Verkupferung von metallischen Gegenständen, wenn diese z.B. aufgrund ihrer Form für eine galvanische Abscheidung nicht geeignet sind, sowie bei der Verkupferung von nichtmetallischen Gegenständen. Im letzteren Falle muß die Oberfläche vor der Verkupferung aktiviert werden. Diese kann beispielsweise mit Hilfe eines Palladium- oder Kupfer-Kolloids geschehen. Die Einzelheiten der Vorbehandlung von nichtmetallischen Oberflächen vor der chemischen Abscheidung von Kupfer sind dem Fachmann bekannt und bedürfen deshalb keiner näheren Erläuterung.

Eine der wichtigsten Anwendungen der chemischen Verkupferung ist die Durchkontaktierung von Leiterplatten, d.h. die Abscheidung von Kupfer in den Bohrlöchern, um den elektrischen Kontakt zwischen den Leiterbahnen auf beiden Seiten der Platte zu ermöglichen ("Bilayer-Platte"). Eine Übersicht über die Herstellung von Leiterplatten, die auch die galvanische Abscheidung von Kupfer umfaßt, wird beispielsweise in dem Buch "Einführung in die Leiterplattentechnologie" (M. Hummel, Eugen Leuze Verlag, D-7968 Saulgau, 1985) gegeben.

Die Bäder zur chemischen Verkupferung sind wäßrige Lösungen, die üblicherweise ein Kupfersalz, Formaldehyd, ein Alkalihydroxid und einen oder mehrere Komplexbildner und ggf. weitere Hilfsmittel enthalten. Während das Kupfersalz, der Formaldehyd und das Alkalihydroxid diejenigen Agenzien sind, die die reduktive Abscheidung vorantreiben, hat der Komplexbildner die Aufgabe, das Ausfallen von Kupferhydroxid zu verhindern und die Konzentration an freien Kupferionen so weit herabzusetzen, daß eine unbeabsichtigte, "wilde" Kupferausfällung vermieden wird. Zusätzlich können Bad hierzu beispielsweise Stabilisatoren in der Größenordnung von einem bis einigen mg/l zugesetzt werden. Solche Stabilisatoren sind z.B. Natriumcyanid, Allylthioharnstoff oder 2,2'-Dipyridylamin. Weitere Ausführungen hierzu sind beispielsweise in der DE-PS 3622090 enthalten.

Für die Verwendung in Chemisch-Kupfer-Bädern sind zahlreiche Komplexbildner bekannt. Hierzu gehören u.a. Polyimine, Triethanolamin, Weinsäure, Gluconsäure, Glucoheptonsäure, diverse Aminosäuren, Nitrilotriessigsäure sowie N,N,N',N'-Tetrakis(2-hydroxypropyl)ethylendiamin und Ethylendiamintetraessigsäure (EDTA). Die beiden letztgenannten Komplexbildner gehören zu den am häufigsten verwendeten. Die Stabilität des Kupfer-Komplexes beeinflußt die Abscheidungsgeschwindigkeit und die Stabilität des Bades. Deshalb muß der Komplexbildner unter Berücksichtigung dieser Gesichtspunkte ausgewählt werden. So haben beispielsweise Bäder, die Weinsäure, Gluconsäure, Aminosäuren, Nitrilotriessigsäure oder N,N,N',N'-Tetrakis(2-hydroxypropyl)ethylendiamin als Komplexbildner enthalten, eine relativ geringe Stabilität. Dagegen werden mit EDTA sehr stabile Bäder erhalten. Zahlreiche Anwender von Chemisch-Kupfer-Bädern verwenden Gemische von Komplexbildnern, um dem Bad so das gewünschte Eigenschaftsbild zu geben.

Wie oben erwähnt, gehören EDTA und N,N,N',N'-Tetrakis(2-hydroxypropyl)ethylendiamin zu den am weitesten verbreiteten Komplexbildnern für Chemisch-Kupfer-Bäder. Sie gestatten es, einen weiten Bereich des Anforderungsspektrums abzudecken. Leider erweisen sich diese Komplexbildner als unzureichend biologisch abbaubar, was zu einer Belastung der Umwelt führt.

In der DE-OS 3706036 werden als Komplexbildner Polyacetale vorgeschlagen, die erhältlich sind aus Dialdehyden und Polyolcarbonsäuren mit mindestens 3 OH-Gruppen und 5 bis 7 C-Atomen. Es wird u.a. die Verwendung dieser Polyacetale in Waschmitteln als Gerüststoffe und zur Verminderung der Vergrauung und Inkrustierung von Textilien beschrieben, wobei die biologische Abbaubarkeit der Polyacetale einen besonderen Vorteil darstellt. Darüber hinaus wird auch auf das Komplexvermögen gegenüber Eisen-, Nickel-, Mangan-, Kupfer-, Calcium-, Magnesium- und Chromionen hingewiesen.

Der vorliegenden Erfindung liegt die Aufgabe zugrunde, neue Komplexbildner für Bäder zur chemischen Abscheidung von Kupfer zur Verfügung zu stellen, die biologisch abbaubar sind und ansonsten den Eigenschaften bisher verwendeter Komplexbildner hinsichtlich Qualität des abgeschiedenen Kupfers und Stabilität des Bades entsprechen.

Die Aufgabe wird erfindungsgemäß dadurch gelöst, daß man als Komplexbildner für Bäder für die chemische Abscheidung von Kupfer Polyacetale verwendet, wie sie in der DE-OS 3706036 vorgeschlagen werden.

Die erfindungsgemäß zu verwendenden Polyacetale werden hergestellt, indem man

a) Dialdehyde der Formel

$$OHC\text{-}A_n\text{-}CHO,$$

in der

$$A = -CH_2-, -CH_2-CH_2-, -CH_2-CH_2-CH_2-, -CH_2-CH_2-CH_2-CH_2-,$$

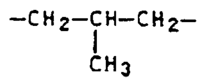 und 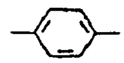

bedeutet und

n = 0 oder 1 ist, mit

b) mindestens 2 OH-Gruppen enthaltenden Polyolcarbonsäuren, die 4 bis 7 C-Atome aufweisen,

im Molverhältnis (a) : (b) von 1 : 0,5 bis 3, Temperaturen von 50 bis 140°C in Gegenwart von sauren Katalysatoren miteinander umsetzt und während der Umsetzung oder danach Wasser aus dem Reaktionsgemisch entfernt.

Diese Polyacetale sind besonders günstig herstellbar und erlauben die Herstellung von Chemisch-Kupfer-Bädern, die zwar nicht ganz die außerordentliche Stabilität wie die mit EDTA hergestellten aufweisen, jedoch stabiler sind als die mit N,N,N',N'-Tetrakis(2-hydroxypropyl)ethylendiamin (Handelsbezeichnung Quadrol) angesetzten. Besonders erstaunlich und nicht vorhersehbar ist, daß die Badstabilität erheblich besser ist als bei der Verwendung von Gluconsäure selbst. Somit ergibt sich gegenüber dem bisherigen Stand der Technik als nicht vorhersehbarer Effekt, daß neue, günstig herstellbare Komplexbildner für die chemische Verkupferung zur Verfügung gestellt werden, die im Rahmen des bekannten Spektrums relativ stabile Komplexe bilden und darüber hinaus biologisch abbaubar sind.

Gegenstand der vorliegenden Erfindung ist daher die Verwendung von Polyacetalen, die erhältlich sind durch die Umsetzung von

a) Dialdehyden der Formel

$$OHC\text{-}A_n\text{-}CHO,$$

in der

$$A = -CH_2-, -CH_2-CH_2-, -CH_2-CH_2-CH_2-, -CH_2-CH_2-CH_2-CH_2-,$$

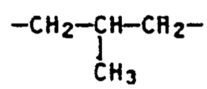 und 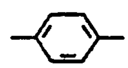

bedeutet und

n = 0 oder 1 ist, mit

b) mindestens 2 OH-Gruppen enthaltenden Polyolcarbonsäuren, die 4 bis 7 C-Atome aufweisen,

im Molverhältnis (a) : (b) von 1 : 0,5 bis 3 in Gegenwart von sauren Katalysatoren als Komplexbildner in Bädern für die chemische Abscheidung von Kupfer sowie ein Verfahren zur chemischen Abscheidung von Kupfer, bei dem man der Badflüssigkeit als Komplexbildner dem Bad ein Polyacetal, wie oben definiert, zusetzt.

Die Komponenten (a) und (b) werden vorzugsweise im Molverhältnis 1 : 0,7 bis 2,5 bei Temperaturen von 60 bis 110°C zur Reaktion gebracht. Von den erfindungsgemäß zu verwendenden Polyacetalen sind die bevorzugt, die durch die Umsetzung von Glyoxal oder Glutardialdehyd mit Gluconsäure oder Glucoheptonsäure erhalten werden. Besonders bevorzugt sind die Polyacetale, die durch die Umsetzung von Glyoxal mit Gluconsäure im Molverhältnis 1 : 0,7 bis 1 : 2,5 erhalten werden.

Die erfindungsgemäß zu verwendenden Polyacetale werden den üblichen wäßrigen Badzusammensetzungen für die chemische Verkupferung in an sich bekannter Weise zugesetzt, d.h. in gleichen Konzentrationen wie bisher verwendete Komplexbildner. Zweckmäßige Konzentrationen sind Mengen von etwa 10 bis 40 g/l Badflüssigkeit.

Dabei weisen die Bäder die üblichen pH-Werte von ≥ 10 auf.

Als Kupferverbindungen werden bevorzugt kristallines Kupfersulfat oder Kupfer(II)-Chlorid verwendet. Das Reduktionsmittel Formaldehyd wird in Mengen von 1 bis 12 g/l zugesetzt.

Gegebenenfalls kommen noch zusätzlich als Hilfsmittel die bereits oben erwähnten Stabilisatoren sowie übliche Tenside in Betracht.

Die Temperaturen der Bäder bei der Verkupferung betragen in der Regel 15 bis 50°C, bevorzugt 20 bis 30°C. Die Verkupferung erfolgt in einem Zeitraum von 5 bis 60 min, bevorzugt 10 bis 40 min.

Als beispielshafte Zusammensetzung eines Bades zur chemischen Verkupferung sei folgende allgemeine Vorschrift angegeben :

| | |
|---|---|
| $CuSO_4 \times 5\ H_2O$ | 5 - 20 g/l |
| NaOH | 12 - 50 g/l |
| Formaldehyd (ber. auf 100 %) | 1 - 12 g/l |
| Komplexbildner, erfindungsgemäß | 10 - 40 g/l |
| Stabilisatoren (z.B. NaCN) | 0,1 - 5 mg/l |
| Tenside | 0,01 - 0,5 g/l |
| Wasser | ad 1 l |

Nach der Erfindung können beispielsweise verkupfert werden :

Leiterplatten aus Phenolharz/Papier, Epoxidharz (Glasfaser-verstärkt), Keramik, Polysulfon oder Werkstücke aus Polyamid, Polycarbonat, Polyester, Polystyrol, Polyethylen, Polytetrafluorethylen u.a.

Zur Herstellung der erfindungsgemäß eingesetzten Polyacetale, wie sie oben definiert werden, sei noch ausgeführt :

Geeignete Dialdehyde der Komponente (a) sind beispielsweise Glyoxal, Malondialdehyd, Succindialdehyd, Glutardialdehyd, Adipindialdehyd oder Terephthaldialdehyd. Auch Mischungen der genannten Dialdehyde können bei der Synthese der Polyacetale eingesetzt werden. Außerdem ist es möglich, Derivate von Dialdehyden einzusetzen, die unter den Synthesebedingungen in die zugrundeliegenden Dialdehyde zerfallen, z.B. offenkettige Acetale, wie Glyoxaltetramethylacetal, Glyoxaltetraethylacetal oder Glutardialdehydtetramethylacetal, Halbacetale, wie 2,3-Dihydroxy-1,4-dioxan und Disulfate von Dialdehyden, z.B. Glyoxaldisulfat. Vorzugsweise verwendet man als Dialdehyde bei der Synthese der Polyacetale wäßrige Lösungen von Glyoxal oder Glutardialdehyd oder Mischungen davon.

Die als Komponente (b) in Betracht kommenden Polyolcarbonsäuren leiten sich von Mono- oder Dicarbonsäuren ab, die 4 bis 7 Kohlenstoffatome und mindestens 2 OH-Gruppen im Molekül enthalten. Hierbei handelt es sich beispielsweise um folgende Zuckercarbonsäuren : Ribonsäure, Lyxonsäure, Mannonsäure, Altronsäure, Allonsäure, Gluconsäure, 2-Ketogluconsäure, 2,5-Diketogluconsäure, Gulonsäure, Idonsäure, Xylonsäure, Talonsäure, Galactonsäure, Mannozuckersäure, Glucarsäure, Galactarsäure, Alloschleimsäure, Glucoheptonsäure, Taloschleimsäure, Idozuckersäure bzw. deren Lactone oder Dilactone. Vorzugsweise verwendet man als Komponente (b) Gluconsäure und/oder Glucoheptonsäure.

Die Komponenten (a) und (b) werden im Molverhältnis von 1 : 0,5 bis 3,0, vorzugsweise im Molverhältnis 1 : 0,7 bis 2,5 miteinander zur Reaktion gebracht. Um einen möglichst weitgehenden Reaktionsablauf zu gewährleisten, wird die Reaktion in Gegenwart von sauren Katalysatoren durchgeführt. Hierbei handelt es sich um starke, nichtflüchtige Säuren die einen pKa-Wert von unterhalb 1 besitzen. Geeignete Katalysatoren sind beispielsweise p-Toluolsulfonsäure, Schwefelsäure, Amidosulfonsäure, Methansulfonsäure und Benzolsulfonsäure.

Als saure Katalysatoren eignen sich auch Ionenaustauscher, die saure Gruppen enthalten, z.B. $SO_3H$- oder COOH-Gruppen. Die Katalysatoren werden, bezogen auf die bei der Reaktion eingesetzten Komponenten (a) und (b), in einer Menge von 0,5 bis 10, vorzugsweise 1 bis 5 Gew.% angewendet. Die Umsetzung kann innerhalb eines breiten Temperaturintervalls durchgeführt werden, z.B. von 25 bis 140, vorzugsweise bei 60 bis 110°C. Sofern die Temperatur oberhalb der Siedetemperatur des jeweils verwendeten Reaktionsgemisches liegen sollte, wird die Reaktion unter erhöhtem Druck, z.B. in einem Autoklaven, durchgeführt. Üblicherweise wird die Umsetzung bei Normaldruck durchgeführt, sie kann jedoch auch unter vermindertem Druck vorgenommen werden. Die Umsetzung der Komponenten (a) und (b) erfolgt, bevorzugt in wäßrigem Medium, bei einer Konzentration der Komponenten (a) und (b) von zusammen 20 bis 80, vorzugsweise 30 bis 70 Gew.%.

Die Umsetzung kann auch in Gegenwart eines inerten organischen Lösemittels durchgeführt werden, in dem die Polyacetale unlöslich sind. Sie fallen dann in feinteiliger Form an. Als inerte organische Lösemittel kommen sowohl aliphatische als auch aromatische Kohlenwasserstoffe in Betracht, z.B. Pentan, Hexan, Cyclohexan, Heptan, n-Octan, iso-Octan, Nonan, Decan, Methylcyclohexan, Benzol, Toluol, o-Xylol, p-Xylol, m-Xylol, Ethylbenzol und Isopropylbenzol. Außerdem können chlorierte Kohlenwasserstoffe, wie Chloroform, Tetrachlorkohlenstoff, Methylenchlorid und Tetrachlorethan als inerte organische Lösemittel verwendet werden. Das

Gewichtsverhältnis der Menge an inertem organischem Lösemittel zur verwendeten Wassermenge beträgt etwa 10 : 1 bis etwa 1 : 10 und liegt vorzugsweise im Bereich von 5 : 1 bis 1 : 2. Das als Lösemittel verwendete Wasser und das bei der Reaktion von (a) mit (b) entstehende Wasser wird zur Herstellung der Polyacetale aus dem Reaktionsgemisch entfernt. Pro Mol Polycarbonsäure, d.h. Komponente (b), werden bei der Herstellung der Polyacetale aus (a) und (b) 0,5 bis 3,5, vorzugsweise 0,8 bis 3,0 Mol Wasser gebildet und aus dem Reaktionsgemisch entfernt.

Die Umsetzung der Komponenten (a) und (b) kann zusätzlich in Gegenwart eines Wasser-in-Öl-Emulgators durchgeführt werden.

Die Reaktion der Dialdehyde mit den Polyolcarbonsäuren kann kontinuierlich oder diskontinuierlich durchgeführt werden. Man kann beispielsweise einen Teil einer wäßrigen Lösung eines Dialdehyds und einer Polycarbonsäure in einem Reaktor vorlegen und in dem Temperaturbereich von 25 bis 140°C zunächst vollständig umsetzen und anschließend den verbleibenden Teil absatzweise oder kontinuierlich zugeben und daraus das Polyacetal bilden. Der Katalysator kann beispielsweise vorgelegt werden oder auch mit einer oder beiden Reaktionskomponenten in den Reaktor dosiert werden. Das Wasser wird während oder im Anschluß an die Polyacetalbildung aus dem Reaktor abdestilliert. Man kann jedoch auch so verfahren, daß man eine Wasser-in-Öl-Emulsion im Reaktor vorlegt und die Komponenten (a) und (b) getrennt oder in Mischung zu der Wasser-in-Öl-Emulsion zulaufen läßt. Der Katalysator kann bereits zusammen mit der Wasser-in-Öl-Emulsion vorgelegt oder zusammen mit den Komponenten (a) und (b) oder auch getrennt davon in den Reaktor dosiert werden. Sofern man ein inertes organisches Lösemittel oder Lösemittelgemische bei der Polyacetalbildung mitverwendet, erfolgen Polyacetalbildung und Entfernung des Wassers aus dem System vorzugsweise gleichzeitig. Das Wasser wird dabei azeotrop aus dem Reaktionsgemisch entfernt. Die Polyacetale fallen dann in feinteiliger Form an. Es ist selbstverständlich, daß während der Reaktion für eine gute Durchmischung der Komponenten gesorgt werden muß, z.B. wird das Reaktionsgemisch gerührt. Man erhält Polyacetale, die in Wasser löslich sind. Die Viskosität 40%iger wäßriger Lösungen bei einer Temperatur von 25°C beträgt z.B. 5 bis 1000 mPas und in einigen Fällen auch mehr als 1000, z.B. 1800 mPas. Bei den reinen Polyacetalen ist unterhalb von 300°C kein definierter Schmelzpunkt feststellbar. Die IR-Spektren der Polyacetalcarbonsäuren zeigen in der Regel Schwingungsbanden bei 3430 $cm^{-1}$ (breit), 2930 $cm^{-1}$, 1780 $cm^{-1}$ und 1740 $cm^{-1}$ und mehrere Banden zwischen 1200 und 1000 $cm^{-1}$ sowie bei 930 $cm^{-1}$.

I. Herstellungsbeispiele für Polyacetale

Beispiel 1

In einem mit Rührer, Wasserabscheider und Rückflußkühler versehenen Kolben mischt man 298 g (0,66 mol) 50%ige wäßrige Glucoheptonsäure, 47,9 g (0,33 mol) 40%iges wäßriges Glyoxal und setzt dann 6,6 g p-Toluolsulfonsäure-monohydrat und 350 g Chloroform zu. Das Gemisch wird unter Rühren zum Rückflußsieden erhitzt. Mit Hilfe des Wasserabscheiders wird das mit den Ausgangsstoffen eingebrachte und während der Reaktion entstandene Wasser azeotrop abdestilliert. Innerhalb von 6 Stunden werden 189 g Wasser azeotrop aus dem Reaktionsgemisch abdestilliert. Im Verlauf der Umsetzung bildet sich ein Niederschlag, der nach Beendigung der Umsetzung und nach dem Abkühlen des Reaktionsgemisches auf Raumtemperatur abfiltriert wird. Der Niederschlag wird anschließend bei 25°C im Vakuum getrocknet. Man erhält 151 g eines festen Produktes.

Beispiel 2

In der in Beispiel 1 beschriebenen Apparatur mischt man 196 g (0,5 mol) 50%ige wäßrige Gluconsäure, 72,6 g (0,5 mol) 40%iges wäßriges Glyoxal und 9,8 g p-Toluolsulfonsäure-monohydrat und 370 g Chloroform. Die Mischung wird intensiv gerührt und 8 Stunden zum Sieden erhitzt. Hierbei scheiden sich insgesamt 155 g Wasser azeotrop ab. Das Reaktionsgemisch wird dann abgekühlt und das Chloroform nach dem Absetzen vom festen Rückstand abdekantiert. Der Rückstand wird im Vakuum bei 25°C getrocknet. Man erhält 115 g Polyacetal.

Beispiel 3

In der in Beispiel 1 beschriebenen Apparatur wird eine Mischung aus 235,2 g (0,6 mol) 50%iger wäßriger Gluconsäure, 43,5 g (0,3 mol) 40%igem Glyoxal, 5,0 g p-Toluolsulfonsäure-monohydrat und 390 g Toluol unter Rühren zum Sieden erhitzt. Innerhalb von 4 Stunden werden 151 g Wasser azeotrop abdestilliert. Das Reaktionsgemisch wird dann gekühlt, der feinteilige Rückstand abfiltriert und im Vakuum getrocknet. Man erhält

121 g Polyacetals.

Beispiel 4

Es wird wie in Beispiel 3 verfahren, wobei allerdings nur 34,8 g (0,24 mol) 40%iges Glyoxal eingesetzt werden. Es werden 146 g Wasser azeotrop abdestilliert. Man erhält 117 g Polyacetal.

Beispiel 5

Man verfährt wie in Beispiel 1, wobei allerdings 63,9 g (0,44 mol) 40%iges wäßriges Glyoxal und 400 g Chloroform eingesetzt werden. Es werden 199 g Wasser azeotrop abdestilliert. Man erhält 156 g Polyacetal.

Beispiel 6

In einem Kolben, der mit Rührer und Wasserabscheider ausgestattet ist, legt man 390 g Toluol, 11,6 g Palmitinsulfonat-natrium (40%ig in Wasser), 6,4 g p-Toluolsulfonsäure-monohydrat und 192,7 g (0,5 mol) 50,9%ige wäßrige Gluconsäure vor. Die Mischung wird intensiv gerührt und zum Sieden erhitzt. Unmittelbar nach Siedebeginn tropft man innerhalb 1 Stunde 200 g (0,5 mol) 25%igen wäßrigen Glutardialdehyd zu. 4 Stunden nach Beginn des Rückflußsiedens sind 278 g Wasser azeotrop abdestilliert. Das Reaktionsgemisch wird dann auf Raumtemperatur abgekühlt, der Niederschlag abgesaugt und im Vakuum bei 25°C getrocknet. Man erhält 126 g Polyacetal.

Beispiel 7

Man verfährt wie in Beispiel 1, wobei jedoch statt Glucoheptonsäure 100,3 g (0,33 mol) 50%ige wäßrige Weinsäure verwendet werden. Es werden 87 g Wasser azeotrop abdestilliert. Man erhält 59 g Polyacetal.

II. Anwendungsbeispiele

Beispiele

Die erfindungsgemäße Verwendung verschiedener Polyacetale als Komplexbildner wird in Bädern zum chemischen Verkupfern von Leiterplattenmaterial aufgezeigt :

Als Substrat werden 15 cm lange und 1 cm breite Stücke einer Phenolharz/Papier-Leiterplatten (FR2) ohne Kupfer-Laminat verwendet. Die Leiterplattenstücke wurden mit Chromschwefelsäure angeätzt und dann jeweils in temperierten Reagenzgläsern in einer kommerziellen Chemisch-Kupfer-Produktlinie gemäß der Arbeitsvorschrift Produktlinie Dynaplate (Vertrieb Fa. Dr. Ing. Max Schlötter GmbH & Co. KG, 7034 Geislingen) vorbehandelt.

Diese Vorbehandlung umfaßt folgende Schritte : Reinigen/(Spülen)/Microetch/(Spülen)/Pre-Dip/Aktivator(Pd-Kolloid)/(Spülen)/Konditioner/(Spülen).

Im Anschluß an diese Vorbehandlung wurde die chemische Verkupferung in den nachstehend beschriebenen Bädern während 10 min. vorgenommen. Schließlich wurde mit 5%iger Schwefelsäure und dann mit Wasser gespült und mit Preßluft getrocknet. Die folgende Tabelle enthält außer den Angaben über die Zusammensetzung der Bäder auch Angaben über ihre Stabilität.

In allen in der Tabelle angeführten Beispielen wird eine vollständige Verkupferung der eingetauchten Leiterplatten-Oberfläche erhalten. Das Vergleichsbeispiel zeigt, daß mit den erfindungsgemäßen Polyacetalen ein stabileres Bad als mit Gluconsäure erhalten wird.

Tabelle: Bäder zur chemischen Abscheidung von Kupfer

| Anwend. Bsp. Nr. | Komplexbildner | Lösung A[2] (Holver-hältnis) | Herst. Bsp. Nr. | Menge [g] | NaOH [g] | $H_2O$ ad | Lösung B[2] $CuSO_4$ $5H_2O$ [g] | Formaldehyd 37 %ig [g] | $H_2O$ ad | Bad.-Temp. [°C] | Stabilität [1] [h] |
|---|---|---|---|---|---|---|---|---|---|---|---|
| 1 | Gluconsäure/Glyoxal | (1:1) | 2 | 1,2 | 1,8 | 50 ml | 0,9 | 3,7 | 50 ml | 25 | über 2 |
| 2 | Gluconsäure/Glyoxal | (2:1) | 3 | 1,2 | 1,8 | 50 ml | 0,9 | 3,7 | 50 ml | 25 | über 3 |
| 3 | Gluconsäure/Glyoxal | (2,5:1) | 4 | 1,2 | 1,8 | 50 ml | 0,9 | 3,7 | 50 ml | 25 | über 1 |
| 4 | Gluconsäure/Glyoxal | (2:1) | 3 | 0,9 | 1,3 | 50 ml | 0,65 | 2,6 | 50 ml | 30 | über 3 |
| 5 | Glucoheptons./Glyoxal | (1,5:1) | 5 | 1,2 | 1,8 | 50 ml | 0,9 | 3,7 | 50 ml | 30 | über 3 |
| 6 | Glucoheptons./Glyoxal | (2:1) | 1 | 1,2 | 1,8 | 50 ml | 0,9 | 3,7 | 50 ml | 25 | über 2 |
| 7 | Gluconsäure/Glutardialdehyd | (1:1) | 6 | 1,2 | 1,8 | 50 ml | 0,9 | 3,7 | 50 ml | 25 | über 1 |
| 8 | Weinsäure/Glyoxal | (1:1) | 7 | 1,2 | 1,8 | 50 ml | 0,9 | 3,7 | 50 ml | 25 | 0,5 |
| 9 Vergleich | Gluconsäure | | | 1,2 | 1,8 | 50 ml | 0,9 | 3,7 | 50 ml | 25 | fällt sofort aus |
| 10 Vergleich | Quadrol | | | 1,2 | 1,8 | 50 ml | 0,9 | 3,7 | 50 ml | 25 | über 1 |

[1]): Stabilität = Zeitraum von der Verkupferung des Leiterplattenstücks bis zum Auftreten von Trübung und Ausfall von Kupfer. Lagerung des Bades nach der Verkupferung bei 23°C.

[2]): Ansetzen des Bades = - getrennte Herstellung der Lösungen A und B.
- Vorlegen von A und Zugabe von B unter Rühren.

## Patentansprüche

1. Verwendung von Polyacetalen, die erhältlich sind durch Umsetzung von
a) Dialdehyden der Formel

$$OHC\text{-} A_n\text{-}CHO,$$

in der

$$A = -CH_2-, -CH_2\text{-}CH_2-, -CH_2\text{-}CH_2\text{-}CH_2-, -CH_2\text{-}CH_2\text{-}CH_2\text{-}CH_2-,$$

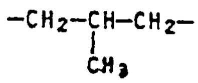 und 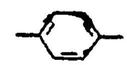

bedeutet und
n = 0 oder 1 ist, mit
b) mindestens 2 OH-Gruppen enthaltenden Polyolcarbonsäuren, die 4 bis 7 C-Atomen aufweisen,
im Molverhältnis (a) : (b) von 1 : 0,5 bis 3 in Gegenwart von sauren Katalysatoren als Komplexbildner in Bädern für die chemische Abscheidung von Kupfer.

2. Verwendung von Polyacetalen nach Anspruch 1, die erhältlich sind durch die Umsetzung von Glyoxal oder Glutardialdehyd mit Gluconsäure oder Glucoheptonsäure im Molverhältnis 1 : 0,7 bis 1 : 2,5.

3. Verwendung von Polyacetalen nach Anspruch 1 oder 2 in einer Menge von 10 bis 40 g/l Badflüssigkeit.

4. Verfahren zur chemischen Abscheidung von Kupfer, bei dem man der Badflüssigkeit als Komplexbildner Polyacetale, wie in Anspruch 1 definiert, zusetzt.

## Claims

1. The use of a polyacetal obtainable by reacting
a) a dialdehyde of the formula

$$OHC\text{-}A_n\text{-}CHO,$$

where A is $-CH_2-, -CH_2\text{-}CH_2-, -CH_2\text{-}CH_2\text{-}CH_2-, -CH_2\text{-}CH_2\text{-}CH_2\text{-}CH_2-,$

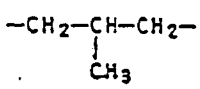 or 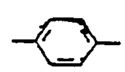

and n is 0 or 1, with
b) a polyolcarboxylic acid which contains 2 or more OH groups and has from 4 to 7 carbon atoms,
in a molar ratio of (a) : (b) of from 1.05 to 1.3 in the presence of an acidic catalyst, as a complexing agent in a bath for the chemical deposition of copper.

2. A use as claimed in claim 1, wherein the polyacetal used is obtainable by reacting glyoxal or glutardialdehyde with gluconic acid or glucoheptonic acid in a molar ratio of from 1 : 0.7 to 1 : 2.5.

3. A use as claimed in claim 1 or 2, wherein the polyacetal is used in an amount of from 10 to 40 g/l of bath liquid.

4. A process for the chemical deposition of copper, which comprises adding a polyacetal as defined in claim 1 to the bath liquid as complexing agent.

## Revendications

1. Utilisation de polyacétals qui sont obtenus par réaction

a) de dialdéhydes de formule

$$OHC\text{-}A_n\text{-}CHO,$$

dans laquelle

$A =$ —$CH_2$—, —$CH_2$-$CH_2$—, —$CH_2$-$CH_2$-$CH_2$—, —$CH_2$-$CH_2$-$CH_2$-$CH_2$—

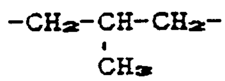 ou 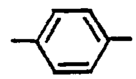 et

n = 0 ou 1, avec

b) des acides polyolcarboxyliques contenant au moins 2 groupements OH, qui renferment de 4 à 7 atomes de carbone,

dans un rapport molaire (a) : (b) de 1 : 0,5 à 3, en présence de catalyseurs acides, comme complexants dans des bains de dépôt chimique de cuivre.

2. Utilisation selon la revendication 1 de polyacétals qui sont obtenus par la réaction de glyoxal ou de dialdéhyde glutarique avec de l'acide gluconique ou de l'acide glucoheptonique dans un rapport molaire de 1 : 0,7 à 1 : 2,5.

3. Utilisation de polyacétals selon la revendication 1 ou 2 dans une proportion de 10 à 40 g/l de liquide du bain.

4. Procédé de dépôt chimique de cuivre, dans lequel on ajoute au liquide du bain, en tant que complexants, des polyacétals tels que définis dans la revendication 1.